# EUROPÄISCHE PATENTSCHRIFT

(11) **EP 2 309 309 B1**
(45) Veröffentlichungstag und Bekanntmachung des Hinweises auf die Patenterteilung: **07.03.2018**
(21) Anmeldenummer: 10183938.9
(22) Anmeldetag: 30.09.2010
(51) Int. Cl.: G02B 27/09, H01S 5/40

(54) **Vorrichtung zur Formung von Laserstrahlung**
Device for shaping laser radiation
Dispositif destiné à la formation de rayons laser

(30) Priorität: 01.10.2009 DE 102009047989
(43) Veröffentlichungstag der Anmeldung: 13.04.2011
(73) Patentinhaber: LIMO Patentverwaltung GmbH & Co. KG, 44319 Dortmund (DE)
(72) Erfinder: Aschke, Lutz, 58300 Wetter (Ruhr) (DE); Bayer, Andreas, 59427 Unna (DE); Fornahl, Udo, 48155 Münster (DE); Meinschien, Jens, 44137 Dortmund (DE); Mitra, Thomas, 40237 Düsseldorf (DE)
(74) Vertreter: Basfeld, Rainer

(56) Entgegenhaltungen:
- EP-A1- 1 006 382
- WO-A1-03/098283
- DE-A1- 19 635 942
- JP-A- H0 996 760
- JP-A- H1 117 268
- US-A- 5 973 853
- US-A1- 2004 240 489
- US-A1- 2007 086 501
- US-B1- 6 700 709

## Beschreibung

Die vorliegende Erfindung betrifft eine Vorrichtung zur Formung von Laserstrahlung gemäß dem Oberbegriff des Anspruchs 1.

Definitionen: In Ausbreitungsrichtung der Laserstrahlung meint mittlere Ausbreitungsrichtung der Laserstrahlung, insbesondere wenn diese keine ebene Welle ist oder zumindest teilweise divergent ist. Mit Laserstrahl, Lichtstrahl, Teilstrahl oder Strahl ist, wenn nicht ausdrücklich anderes angegeben ist, kein idealisierter Strahl der geometrischen Optik gemeint, sondern ein realer Lichtstrahl, wie beispielsweise ein Laserstrahl mit einem Gauß-Profil oder einem Top-Hat-Profil, der keinen infinitesimal kleinen, sondern einen ausgedehnten Strahlquerschnitt aufweist. Licht soll nicht nur den sichtbaren Spektralbereich, sondern auch den infraroten und ultravioletten Spektralbereich bezeichnen.

Eine Vorrichtung der eingangs genannten Art ist aus der JP H11 17268 A bekannt. Bei der darin beschriebenen Vorrichtung ist ein Bauteil vorgesehen auf dessen Eintrittsfläche und auf dessen Austrittsfläche jeweils in Array von Zylinderlinsen vorgesehen ist. Dabei werden die von einem Laserdiodenbarren ausgehenden Laserstrahlungen von den Linsenarrays kollimiert und in einer ersten Ausführungsform von einer hinter dem Bauteil angeordneten separaten Linse zusammen auf eine Lichtleitfaser abgebildet. In einer zweiten Ausführungsform sind die Zylinderlinsen derart gestaltet, dass von den Zylinderlinsen die Laserstrahlungen auf die Lichtleitfaser abgebildet werden. Die zweite Ausführungsform weist dementsprechend keine zusätzliche separate Linse auf.

Eine weitere Vorrichtung zur Formung von Laserstrahlung ist aus der JP H09 96760 A bekannt. Bei der darin beschriebenen Vorrichtung ist ein Bauteil vorgesehen auf dessen Eintrittsfläche eine Zylinderlinse und auf dessen Austrittsfläche ein Array von Zylinderlinsen vorgesehen ist. Dabei werden die von einem Laserdiodenbarren ausgehenden Laserstrahlungen von der Linse auf der Eintrittsfläche hinsichtlich der Fast-Axis auf jeweils eine Mehrzahl von Lichtleitfasern abgebildet und von den Linsen auf der Austrittsseite hinsichtlich der Slow-Axis jeweils auf eine der Lichtleitfasern abgebildet.

Eine weitere Vorrichtung zur Formung von Laserstrahlung ist beispielsweise aus der EP 1 006 382 B1 bekannt. Dort werden die von einem Laserdiodenbarren ausgehenden Laserstrahlen durch eine Kombination aus mehreren Mikrooptiken und Makrooptiken auf die Eintrittsfläche einer Lichtleitfaser fokussiert. Diese Methoden benötigen mehrere Bauteile und Justageschritte zur Einkopplung des Laserdiodenbarrens in eine Faser und somit einen hohen Kosten- und Zeitfaktor bezüglich der Produktion eines fasergekoppelten Laserdiodenmoduls.

Aus der US 6,407,870 B1 ist ein monolithisches Bauteil bekannt, das auf einer Eintrittsfläche ein Array von vertikal und horizontal zueinander versetzten Linsen für die Kollimation der Fast-Axis und auf einer Austrittsfläche ein Array von vertikal und horizontal zueinander versetzten Linsen für die Kollimation der Slow-Axis aufweist. Auch bei dieser Vorrichtung müssen in Ausbreitungsrichtung der Laserstrahlung hinter dem Bauteil Mittel zur Fokussierung der einzelnen Laserstrahlen auf eine Eintrittsfläche einer Lichtleitfaser angeordnet sein. Weiterhin müssen vor dem Bauteil Mittel zur vertikalen Versetzung der einzelnen Laserstrahlen vorgesehen sein, damit die einzelnen Laserstrahlen eines Laserdiodenbarrens auf die vertikal versetzt angeordneten Zylinderlinsen auftreffen können.

Das der vorliegenden Erfindung zugrunde liegende Problem ist die Schaffung einer Vorrichtung der eingangs genannten Art, die einfacher und/oder kostengünstiger und/oder effektiver aufgebaut ist.

Dies wird erfindungsgemäß durch eine Vorrichtung der eingangs genannten Art mit den kennzeichnenden Merkmalen des Anspruchs 1 erreicht. Die Unteransprüche betreffen bevorzugte Ausgestaltungen der Erfindung.

Gemäß Anspruch 1 ist vorgesehen, dass die ersten und die zweiten Linsenmittel an einem Bauteil realisiert sind. Damit kann die Fasereinkopplung mit einem einzelnen Bauteil realisiert werden, so dass die Kosten für eine entsprechende Vorrichtung reduziert werden können.

Weiterhin ist gemäß Anspruch 1 vorgesehen, dass sowohl die ersten, als auch die zweiten Linsenmittel eine Abbildung der Laserstrahlung auf die Eintrittsfläche einer Lichtleitfaser bewirken können. Weiterhin ist vorgesehen, hinsichtlich der Slow-Axis-Richtung der von einem Laserdiodenbarren ausgehenden Laserstrahlen ein Array von Zylinderlinsen vorzusehen, mittels dem zumindest einige der Laserstrahlen auf die Eintrittsfläche der Lichtleitfaser abgelenkt werden können.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine Seitenansicht einer erfindungsgemäßen Vorrichtung mit von der Vorrichtung geformter Laserstrahlung;
- Fig. 2: eine Draufsicht auf die Vorrichtung mit von der Vorrichtung geformter Laserstrahlung gemäß Fig. 1;
- Fig. 3: eine Seitenansicht einer erfindungsgemäßen Vorrichtung mit anschließender Lichtleitfaser und von der Vorrichtung geformter Laserstrahlung;
- Fig. 4: eine Draufsicht auf die Vorrichtung mit anschließender Lichtleitfaser und von der Vorrichtung geformter Laserstrahlung gemäß Fig. 3.

In den Figuren sind kartesische Koordinatensysteme eingefügt, um eine bessere Orientierung zu ermöglichen.

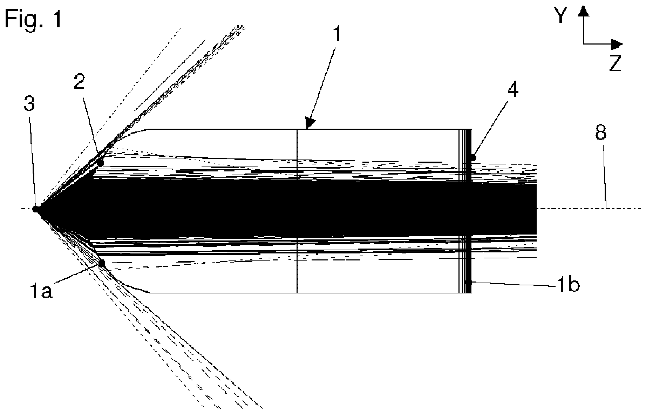

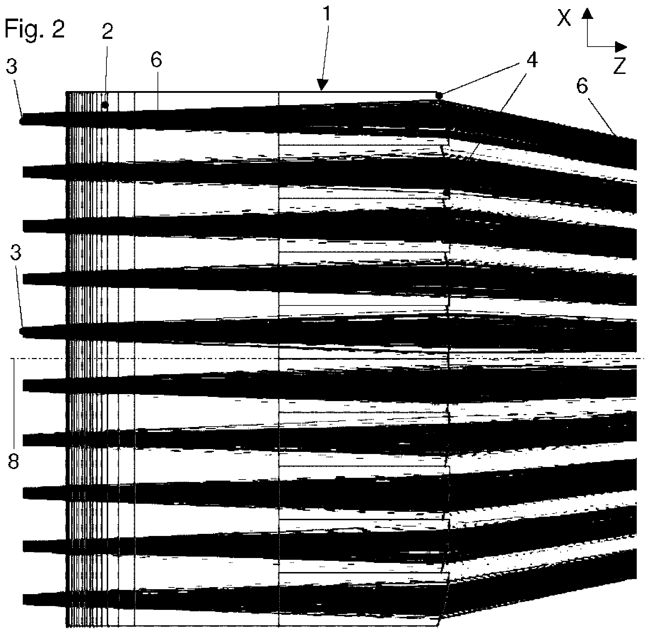

Aufgabe der Erfindung ist die Reduzierung der Strahlformung auf ein Minimum an Bauteilen (einteilige, monolithische Mikrooptik) und Justageschritten, und damit die kostengünstige Produktion eines fasergekoppelten Laserdiodenmoduls. Erreicht wird diese Strahlformung durch ein einzelnes, monolithisches und mikrooptisches Bauteil 1 (siehe Fig. 1 und 2), welches auf einer ersten, als Eintrittsfläche dienenden Fläche 1a eine erste Zylinderlinse 2 und auf einer zweiten, als Austrittsfläche dienenden Fläche 1b ein dazu um 90° gedrehtes Array von zweiten Zylinderlinsen 4 aufweist.

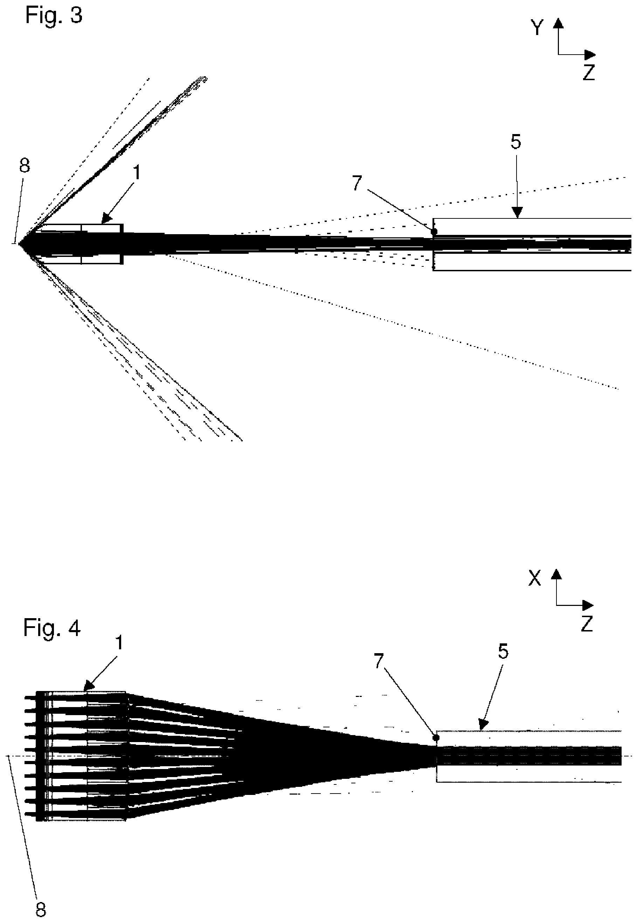

Die von den Emittern 3 eines Laserdiodenbarrens ausgehenden Laserstrahlen 6 werden von der ersten Zylinderlinse 2 in der Fast-Axis-Richtung beziehungsweise der Y-Richtung direkt auf die Eintrittsfläche 7 der Lichtleitfaser 5 abgebildet. Die zweiten Zylinderlinsen 4 bilden jeden einzelnen Laserstrahl 6 in der Slow-Axis-Richtung beziehungsweise der X-Richtung, im abgebildeten Ausführungsbeispiel dezentriert, auf die Eintrittsfläche 7 der Lichtleitfaser 5 (siehe Fig. 3 und 4) ab.

Dabei sind insbesondere die in X-Richtung äußeren beziehungsweise in Fig. 2 oberen und unteren zweiten Zylinderlinsen 4 derart unsymmetrisch, dass die außerhalb der Mitte liegenden Laserstrahlen 6 zur Mitte beziehungsweise zur optischen Achse 8 des Bauteils 1 hin abgelenkt werden (siehe Fig. 2 und Fig. 4). Dagegen sind die in der Mitte des Arrays beziehungsweise angrenzend an die optische Achse 8 angeordneten zweiten Zylinderlinsen 4 symmetrisch oder nur sehr wenig unsymmetrisch. Die Symmetrie der zweiten Zylinderlinsen 4 nimmt von der Mitte nach außen beziehungsweise in Fig. 2 nach oben und nach unten ab. Insbesondere kann die optische Achse 8 des Bauteils 1 der optischen Achse der Lichtleitfaser entsprechen beziehungsweise koaxial zu dieser sein.

In Fig. 1 und Fig. 2 ist das Strahlformungsprinzip gut zu erkennen. Durch das Ausführungsbeispiel wird es ermöglicht, einen Minibarren (10 Emitter, 100/500ter Struktur) direkt und ohne weitere Makrooptiken in eine 600µm Faser mit einer NA = 0,22 einzukoppeln. Es ergibt sich eine theoretische Kopplungseffizienz (rein geometrische optische Verluste ohne Reflexionsverluste) von etwa 95%. Gemessen wurde eine Kopplungseffizienz von 90% ± 3%.

Wenn die Laserstrahlung eines Stacks von Laserdiodenbarren in eine Lichtleitfaser 5 eingekoppelt werden soll, können mehrere in Y-Richtung übereinander angeordnete erste Zylinderlinsen 2 vorgesehen werden. Diese sind dabei so gegeneinander verkippt, dass die von unterschiedlichen Laserdiodenbarren ausgehenden Laserstrahlen hinsichtlich der Fast-Axis beziehungsweise der Y-Richtung zur Mitte beziehungsweise zur optischen Achse 8 hin abgelenkt werden (zur Lage der optischen Achse in Y-Richtung siehe schematisch Fig. 1).

## Patentansprüche

1. Vorrichtung zur Formung von Laserstrahlung, wobei die Vorrichtung zur Formung der von einem Laserdiodenbarren mit einer Mehrzahl von in einer zweiten Richtung (X) nebeneinander angeordneten Emittern (3) oder einem Stack von Laserdiodenbarren mit jeweils einer Mehrzahl von in der zweiten Richtung (X) nebeneinander angeordneten Emittern (3) ausgehenden Laserstrahlen (6) dienen kann und die Laserstrahlung derart formen kann, dass die Laserstrahlung in eine Lichtleitfaser (5) eintreten kann, umfassend
- ein einzelnes Bauteil (1), mit dem die Einkopplung in die Lichtleitfaser (5) realisiert werden kann,
- erste Linsenmittel zur Ablenkung und/oder Abbildung oder Kollimation der Laserstrahlung hinsichtlich einer ersten Richtung (Y), wobei die ersten Linsenmittel von refraktiven Strukturen in einer ersten Fläche (1a) des Bauteils (1) gebildet werden, wobei die erste Fläche (1a) als Eintrittsfläche für die Laserstrahlung dienen kann, wobei die ersten Linsenmittel mindestens eine erste Zylinderlinse (2) umfassen, die derart ausgebildet ist, dass sie die Laserstrahlen (6) des Laserdiodenbarrens oder des Stacks von Laserdiodenbarren auf die Eintrittsfläche (7) einer Lichtleitfaser (5) hinsichtlich der ersten Richtung (Y) abbilden kann, sowie
- zweite Linsenmittel zur Ablenkung und/oder Abbildung oder Kollimation der Laserstrahlung hinsichtlich der zweiten Richtung (X), wobei die zweiten Linsenmittel von refraktiven Strukturen in einer zweiten Fläche (1b) des Bauteils (1) gebildet werden, wobei die zweite Fläche (1b) der ersten Fläche (1a) gegenüberliegt und als Austrittsfläche für die Laserstrahlung dienen kann, wobei die zweiten Linsenmittel als Array von zweiten Zylinderlinsen (4) ausgebildet sind, und wobei zumindest einige der zweiten Zylinderlinsen (4) des Arrays von zweiten Zylinderlinsen (4) derart ausgebildet sind, dass sie die Laserstrahlen (6) des Laserdiodenbarrens oder des Stacks von Laserdiodenbarren auf die Eintrittsfläche (7) einer Lichtleitfaser (5) hinsichtlich der zweiten Richtung (X) abbilden können,
- wobei die ersten und die zweiten Linsenmittel derart gestaltet sind, dass sowohl die ersten, als auch die zweiten Linsenmittel eine Abbildung der Laserstrahlung auf die Eintrittsfläche genau einer Lichtleitfaser (5) bewirken können,
**dadurch gekennzeichnet, dass** zumindest einige der zweiten Zylinderlinsen (4) des Arrays von zweiten Zylinderlinsen (4) unsymmetrisch sind und daher äußere der Laserstrahlen (6) des Laserdiodenbarrens oder des Stacks von Laserdiodenbarren Laserstrahlen (6) stärker als innere der Laserstrahlen (6) des Laserdiodenbarrens oder des Stacks von Laserdiodenbarren hinsichtlich der zweiten Richtung (X) ablenken können, und **dass** eine jede der zweiten Zylinderlinsen (4) einem der Emitter (3) zugeordnet ist und den von dem jeweiligen Emitter (3) ausgehenden Laserstrahl (6) hinsichtlich der zweiten Richtung (X) ablenkt.

2. Vorrichtung nach Anspruch 1, **dadurch gekennzeichnet, dass** das Bauteil (1) ein monolithisches Bauteil (1) ist.

3. Vorrichtung nach einem der Ansprüche 1 oder 2, **dadurch gekennzeichnet, dass** die erste Richtung (Y) der Fast-Axis und die zweite Richtung (X) der Slow-Axis entspricht.

4. Vorrichtung nach einem der Ansprüche 1 bis 3, **dadurch gekennzeichnet, dass** die mindestens eine erste Zylinderlinse (2) senkrecht zu den zweiten Zylinderlinsen (4) ausgerichtet ist.

5. Vorrichtung nach einem der Ansprüche 1 bis 4, **dadurch gekennzeichnet, dass** sämtliche der zweiten Zylinderlinsen (4) des Arrays von zweiten Zylinderlinsen (4) derart ausgebildet sind, dass sie die Laserstrahlen (6) des Laserdiodenbarrens oder des Stacks von Laserdiodenbarren auf die Eintrittsfläche (7) einer Lichtleitfaser (5) hinsichtlich der zweiten Richtung (X) abbilden können.

6. Vorrichtung nach einem der Ansprüche 1 bis 5, **dadurch gekennzeichnet, dass** die ersten Linsenmittel eine Mehrzahl von in der ersten Richtung (Y) nebeneinander angeordneten ersten Zylinderlinsen (2) aufweisen, wobei unterschiedliche der ersten Zylinderlinsen (2) die Laserstrahlen (6) von unterschiedlichen Laserdiodenbarren eines Stacks von Laserdiodenbarren hinsichtlich der ersten Richtung (Y) unterschiedlich ablenken können.

## Claims

1. Apparatus for forming laser radiation, wherein the apparatus can serve for forming the laser beams (6) which originate from a laser diode bar with a plurality of emitters (3) arranged adjacent to each other in a second direction (X) or a stack of laser diode bars, each with a plurality of emitters (3) arranged adjacent to each other in the second direction (X), and can form the laser radiation such that the laser radiation can enter an optical fiber (5), comprising:
- a single component (1) for realising the coupling in the optical fiber (5);
- first lens means for deflection and/or imaging or collimation of the laser radiation with respect to a first direction (Y), wherein the first lens means are formed by refractive structures in a first area (1a) of the component (1), wherein the first area (1a) can serve as an inlet area for the laser radiation, wherein the first lens means comprise at least one first cylindrical lens (2) which is configured such that it can image the laser beams (6) of the laser diode bar or of the stack of laser diode bars on the inlet area (7) of an optical fiber (5) with respect to the first direction (Y), and
- second lens means for deflection and/or imaging or collimation of the laser radiation with respect to the second direction (X), wherein the second lens means are formed from refractive structures in a second area (1b) of the component (1), wherein the second area (1b) is opposite the first area (1a) and can serve as an outlet area for the laser radiation, wherein the second lens means are formed as an array of second cylindrical lenses (4), and wherein at least some of the second cylindrical lenses (4) of the array of second cylindrical lenses (4) are configured such that they can image the laser beams (6) of the laser diode bar or of the stack of laser diode bars on the inlet area (7) of an optical fiber (5) with respect to the second direction (X),
- wherein the first and second lens means are configured such that the first and the second lens means can effect imaging of the laser radiation on the inlet area of exactly one optical fiber (5),
**characterised in that** at least some of the second cylindrical lenses (4) of the array of second cylindrical lenses (4) are asymmetric, and can therefore deflect outer laser beams (6) of the laser beams (6) of the laser diode bar or of the stack of laser diode bars to a greater extent than inner laser beams (6) of the laser diode bar or of the stack of laser diode bars with respect to the second direction (X), and **in that** each of the second cylindrical lenses (4) is associated with one emitter (3) and deflects the laser beam (6) originating from the respective emitter (3) with respect to the second direction (X).

2. Apparatus according to claim 1, **characterised in that** the component (1) is a monolithic component (1).

3. Apparatus according to any of claims 1 or 2, **characterised in that** the first direction (Y) corresponds to the fast-axis and the second direction (X) corresponds to the slow-axis.

4. Apparatus according to any of claims 1 to 3, **characterised in that** the at least one first cylindrical lens (2) is aligned vertically to the second cylindrical lenses (4).

5. Apparatus according to any of claims 1 to 4, **characterised in that** all of the second cylindrical lenses (4) of the array of second cylindrical lenses (4) are configured such that they can image the laser beams (6) of the laser diode bar or of the stack of laser diode bars on the inlet area (7) of an optical fiber (5) with respect to the second direction (X).

6. Apparatus according to any of claims 1 to 5, **characterised in that** the first lens means comprises a plurality of first cylindrical lenses (2) arranged adjacent to each other in the first direction (Y), wherein different ones of the first cylindrical lenses (2) can differently deflect the laser beams (6) of different laser diode bars of a stack of laser diode bars with respect to the first direction (Y).

## Revendications

1. Dispositif de formation de rayonnement laser, dans lequel le dispositif peut servir à former les faisceaux laser (6) partant d'une barre de diodes laser avec une pluralité d'émetteurs (3) disposés les uns à côté des autres dans une deuxième direction (X) ou d'une pile de barres de diodes laser avec respectivement une pluralité d'émetteurs (3) disposés les uns à côté des autres dans la deuxième direction (X), et peut former le rayonnement laser de telle sorte que le rayonnement laser peut entrer dans une fibre optique (5), comprenant
- un composant (1) individuel avec lequel l'injection dans la fibre optique (5) peut être réalisée,
- des premiers moyens de lentille pour dévier et/ou reproduire ou collimater le rayonnement laser en ce qui concerne une première direction (Y), dans lequel les premiers moyens de lentille sont formés par des structures réfractives dans une première surface (1a) du composant (1), dans lequel la première surface (1a) peut servir de surface d'entrée pour le rayonnement laser, dans lequel les premiers moyens de lentille comprennent au moins une première lentille cylindrique (2) qui est réalisée de telle sorte qu'elle peut reproduire les faisceaux laser (6) de la barre de diodes laser ou de la pile de barres de diodes laser sur la surface d'entrée (7) d'une fibre optique (5) en ce qui concerne la première direction (Y), ainsi que
- des deuxièmes moyens de lentille pour dévier et/ou reproduire ou collimater le rayonnement laser en ce qui concerne la deuxième direction (X), dans lequel les deuxièmes moyens de lentille sont formés par des structures réfractives dans une deuxième surface (1b) du composant (1), dans lequel la deuxième surface (1b) est en face de la première surface (1a) et peut servir de surface de sortie pour le rayonnement laser, dans lequel les deuxièmes moyens de lentille sont réalisés en tant que réseau de deuxièmes lentilles cylindriques (4), et dans lequel au moins certaines des deuxièmes lentilles cylindriques (4) du réseau de deuxièmes lentilles cylindriques (4) sont réalisées de telle sorte qu'elles peuvent reproduire les faisceaux laser (6) de la barre de diodes laser ou de la pile de barres de diodes laser sur la surface d'entrée (7) d'une fibre optique (5) en ce qui concerne la deuxième direction (X),
- dans lequel les premiers et les deuxièmes moyens de lentille sont conformés de telle sorte que les premiers tout comme les deuxièmes moyens de lentille peuvent causer une reproduction du rayonnement laser sur la surface d'entrée précisément d'une fibre optique (5),
**caractérisé en ce qu'**au moins certaines des deuxièmes lentilles cylindriques (4) du réseau de deuxièmes lentilles cylindriques (4) sont asymétriques et, par conséquent, des extérieurs parmi les faisceaux laser (6) de la barre de diodes laser ou de la pile de barres de diodes laser peuvent dévier des faisceaux laser (6) de manière plus puissante que des intérieurs parmi les faisceaux laser (6) de la barre de diodes laser ou de la pile de barres de diodes laser en ce qui concerne la deuxième direction (X), et **que** chacune des deuxièmes lentilles cylindriques (4) est affectée à un des émetteurs (3) et dévie le faisceau laser (6) partant de l'émetteur (3) respectif en ce qui concerne la deuxième direction (X).

2. Dispositif selon la revendication 1, **caractérisé en ce que** le composant (1) est un composant monolithique (1).

3. Dispositif selon l'une quelconque des revendications 1 ou 2, **caractérisé en ce que** la première direction (Y) correspond à l'axe rapide et la deuxième direction (X), à l'axe lent.

4. Dispositif selon l'une quelconque des revendications 1 à 3, **caractérisé en ce que** l'au moins une première lentille cylindrique (2) est orientée verticalement par rapport aux deuxièmes lentilles cylindriques (4).

5. Dispositif selon l'une quelconque des revendications 1 à 4, **caractérisé en ce que** la totalité des deuxièmes lentilles cylindriques (4) du réseau de deuxièmes lentilles cylindriques (4) sont réalisées de telle sorte qu'elles peuvent reproduire les faisceaux laser (6) de la barre de diodes laser ou de la pile de barres de diodes laser sur la surface d'entrée (7) d'une fibre optique (5) en ce qui concerne la deuxième direction (X).

6. Dispositif selon l'une quelconque des revendications 1 à 5, **caractérisé en ce que** les premiers moyens de lentille présentent une pluralité de premières lentilles cylindriques (2) disposées les unes à côté des autres dans la première direction (Y), dans lequel des différentes parmi les premières lentilles cylindriques (2) peuvent dévier de manière différente les faisceaux laser (6) de différentes barres de diodes laser d'une pile de barres de diodes laser en ce qui concerne la première direction (Y).
